# EUROPÄISCHE PATENTSCHRIFT

(11) **EP 2 744 106 B1**
(45) Veröffentlichungstag und Bekanntmachung des Hinweises auf die Patenterteilung: **26.08.2020**
(21) Anmeldenummer: 13188683.0
(22) Anmeldetag: 15.10.2013
(51) Int. Cl.: H03G 3/32, B60R 11/02

(54) **Einrichtung und Verfahren zur automatischen Anpassung der Lautstärke von Geräuschen in einem Fahrzeuginnenraum**
Device and method for the automatic adjustment of the sound volume in a vehicle interior
Dispositif et procédé d'adaptation automatique de l'intensité sonore de bruits dans l'habitacle d'un véhicule

(30) Priorität: 17.12.2012 DE 102012223320
(43) Veröffentlichungstag der Anmeldung: 18.06.2014
(73) Patentinhaber: Robert Bosch GmbH, 70442 Stuttgart (DE)
(72) Erfinder: Hoetzer, Dieter, 71706 Markgroeningen (DE); Krautter, Wolfgang, 71229 Leonberg (DE)

(56) Entgegenhaltungen:
- EP-A2- 1 739 546
- DE-A1- 10 052 104
- JP-A- S 644 145
- JP-A- 2005 191 668
- US-A1- 2008 021 706
- US-A1- 2009 160 229

## Beschreibung

Die Erfindung geht von einer Einrichtung und einem Verfahren nach der Gattung der unabhängigen Patentansprüche aus.

Aus EP 319 777 B1 und EP 623 995 B1 sind Einrichtungen und Verfahren zur automatischen, störgeräuschabhängigen Steuerung einer Wiedergabelautstärke einer Audioeinrichtung bekannt. Ziel ist es hierbei jeweils, ein Störgeräusch in einem Fahrzeuginnenraum, welches eine Audiowidergabe zu übertönen droht, zu erfassen und die Wiedergabelautstärke entsprechend dem erfassten Störgeräuschpegel zu steuern, so dass eine ausreichende Verständlichkeit der Audiowiedergabe sichergestellt werden kann.

DE 44 105 32 B4 offenbart eine Reduzierung einer Radio- oder CD- Wiedergabelautstärke in dem Fall, dass gleichzeitig eine Sprach-Anweisung eines FahrzeugNavigationssystems ausgegeben wird.

JP 2011 015 018 A und DE 198 27 197 A1 offenbaren die Erkennung von Sprache im Fahrzeug und die Reduzierung einer Radio-Wiedergabelautstärke bei erkannter Sprache.

Aus JP 2005 191 668 ist eine Vorrichtung zur Erzeugung von Klang bekannt, welche das Klangbild eines Lautsprechers an einem Referenzpunkt verändert, wenn ein Dialogpositionssignal erkannt wird.

US 2009/0160229 A1 offenbart eine Kraftfahrzeugsitzvorrichtung umfassend eine Vorrichtung zum Schwenken eines Sitzes, mittels welcher die Position des Sitzes in Abhängigkeit des Zustands geändert wird, in welchem sich ein Passagier befindet.

JP S64 4145 A offenbart die Reduktion von Geräuschen im Innenraum eines Fahrzeugs, wenn ein Anruf auf dem Autotelephon angenommen wird.

### Vorteile der Erfindung

Die Erfindung, die durch die unabhängigenPatentansprüche definiert ist, hat demgegenüber den Vorteil, dass die Absicht eines Fahrzeuginsassen, ein Gespräch zu führen, frühzeitig erkannt und die Lautstärke von auf den Fahrzeuginnenraum einwirkenden Geräuschquellen schon vor Aufnahme des Gesprächs reduziert wird. Damit wird der Fahrzeuginsasse von einer manuellen Einstellung der Geräuschquelle oder Geräuschquellen entlastet. Dies ist insbesondere für den Fahrzeugführer, der mit der Fahraufgabe beschäftigt ist und dieser seine volle Aufmerksamkeit widmen soll, von Bedeutung, stellt aber auch für andere Fahrzeuginsassen eine Erleichterung dar. Eine besondere Erleichterung wird insbesondere dann erreicht, wenn mehrere Geräuschquellen vorhanden und aktiv sind, wie beispielsweise ein Autoradio, daneben eine Lüftung oder Fahrzeug-Klimatisierung, ein Fahrzeugnavigationssystem, welches akustische Fahrrichtungshinweise ausgibt, ein Mobiltelefon, welches durch akustische Signalisierung den Eingang eines Telefonats anzeigt, eine Freisprecheinrichtung, die akustische Signale eines Telefonats wiedergibt und/oder dergleichen mehr. Eine Geräuschminimierung kann dabei in einer Reduzierung der Wiedergabelautstärke im Fall von beispielsweise Autoradio, Fahrzeugnavigationssystem, Mobiltelefon oder Freisprecheeinrichtung, in einer Reduzierung einer Lüfterdrehzahl im Fall der Lüftung oder Klimatisierung oder auch in einer vollständigen Abschaltung der Geräusche erzeugenden Einrichtung oder Einrichtungen bestehen.

Das Vorliegen oder das Bevorstehen einer Gesprächssituation, welche eine Reduzierung der Geräusche im Fahrzeuginnenraum erfordert oder wünschenswert erscheinen lässt, wird dabei erfindungsgemäß auf Grundlage einer Erfassung und Auswertung oder Bewertung von Aktivitäten des Fahrzeugführers und/oder weiterer Fahrzeuginsassen Fahrzeugs erkannt.

Gemäß einer vorteilhaften Ausprägung der Erfindung wird aus der Betätigung eines Fensterhebers zum Öffnen eines Fahrzeugfensters auf das Vorliegen oder Bevorstehen einer Gesprächssituation erkannt. Die Betätigung des Fensterhebers kann dabei vorteilhaft durch Abgriff eines entsprechenden Steuersignals an einem Bedienelement des Fensterhebers erfasst werden. Es wird dabei davon ausgegangen, dass das Öffnen des Fensters dazu dient, eine verbale Kommunikation mit einer Person außerhalb des Fahrzeugs zu ermöglichen. Dies kann beispielsweise auf das Vorliegen oder Bevorstehen einer verbalen Kommunikation zwischen einem Fahrzeuginsassen und einem Fahrzeugexternen, etwa im Rahmen einer Verkehrs- oder Fahrzeugkontrolle durch die Polizei mit einem Polizeibeamten, mit einem Passanten am Straßenrand zum Fragen nach Weg oder einer sonstigen Information, mit einem Bediensteten eines Schnellimbiss, einer Mautstation oder des Werksschutz oder dergleichen hindeuten.

Erfindungsgemäß wird eine Blick- oder Kopfausrichtung des Fahrzeugführers oder eines weiteren Fahrzeuginsassen erfasst und aus einer Blick- oder Kopfausrichtung in Richtung Fahrzeug-Seitenfenster auf das Vorliegen oder Bevorstehen einer Gesprächssituation erkannt. Die Kopf- oder Blickrichtung kann dabei vorteilhaft mit einer Bilderkennungseinrichtung erfasst, die über eine Kamera verfügt, deren Erfassungsbereich in den Fahrzeuginnenraum und hier insbesondere auf die Sitzplätze im Fahrzeug ausgerichtet ist und die ferner über eine dazugehörige Signalverarbeitung verfügt. Solche Systeme kommen beispielsweise zur Überwachung von Fahrzeugführern im Zusammenhang mit einer Müdigkeits-Erkennung zum Einsatz. Die Kopf- oder Blickausrichtung in Richtung Fahrzeug-Seitenfenster dient ebenfalls als Indiz für ein bevorstehendes oder Gespräche mit einem Fahrzeugexternen.

Mittels der Bilderkennung kann auch die Hand des Fahrzeugführers oder eines weiteren Fahrzeuginsassen, die das Fensterheber-Bedienelement betätigt oder sich in dessen Nähe befindet oder bewegt, erfasst werden.

Sinnvoll kann auch eine Stützung der Gesprächserkennung auf Grundlage der Blickrichtungserkennung durch die zusätzliche Überwachung des Fensterhebers, dessen Betätigungselements und/oder der Position der Hand eines Fahrzeuginsassen, der das Betätigungselement bedient, sein.

In vorteilhafter Weiterbildung der Erfindung können zusätzlich zur Beobachtung der Aktivitäten der Fahrzeuginsassen auch Informationen über eine Bewegung des Fahrzeugs und/oder Informationen über eine Ortsposition des Fahrzeugs ausgewertet werden, um die Annahme des Vorliegens oder Bevorstehens einer Gesprächssituation zu stützen oder zu plausibilisieren.

So kann in den zuvor beschriebenen Situationen bei einer zusätzlichen Reduzierung einer Fahrgeschwindigkeit des Fahrzeugs und/oder einer gleichzeitigen Annäherung des Fahrzeugs an einen Fahrbahnrand auf das Vorliegen oder Bevorstehen einer Gesprächssituation erkannt werden. Dieses Fahrverhalten kann beispielsweise typischerweise beobachtet werden, wenn ein Fahrzeuginsasse einen Passanten nach dem Weg zu einem bestimmten Ziel oder zu anderen Informationen befragen möchte. Dieses Fahrverhalten kann typischerweise auch beispielsweise im Rahmen einer Verkehrs- und/oder Fahrzeugkontrolle durch die Polizei beobachtet werden, wobei üblicherweise eine verbale Kommunikation zwischen Polizeibeamten und Fahrzeugführer erfolgt. Dieses Verhalten kann beispielsweise auch dann beobachtet werden, wenn ein Fahrzeugführer einem nahenden Einsatzfahrzeug mit Einsatzsignal den Weg frei geben möchte. In letzterem Fall erfolgt zwar in der Regel keine verbale Kommunikation mit Außenstehenden, dennoch kann die Reduzierung der Innenraumgeräusche gewünscht sein, um die Wahrnehmung des oder weiterer Einsatzsignale zu erleichtern. Eine Blickwendung Richtung Seitenfenster kann dem Auffinden des Einsatzfahrzeugs im Straßenverkehr dienen.

Die Fahrgeschwindigkeit oder Fahrzeuggeschwindigkeit kann aus den Signalen eines Geschwindigkeitsanzeigers, auch als "Tachometer" oder kurz "Tacho" des Fahrzeugs bezeichnet, entsprechenden Informationen auf einem Datenbus des Fahrzeugs oder beispielsweise auch aus Informationen eines Satellitenortungsempfängers gewonnen werden. Die Information über die Annäherung an einen Fahrbahnrand kann beispielsweise durch eine hochpräzise Eigenortung der Fahrzeugposition und Abgleich mit entsprechend detailgenauen Kartendaten oder durch beispielsweise die Sensorik und Signalverarbeitung eines sogenannten Spurhalteassistenten, auch Spurverlassenswarner oder Lane Departure Warning System genannt, bereitgestellt werden. Ein Spurverlassenswarner erfasst mittels einer in die Umgebung des Fahrzeugs gerichteten Kamera ein Umgebungsbild des Fahrzeugs und bestimmt daraus, beispielsweise durch Erkennung einer Fahrbahnmarkierung im Kamerabild und durch Vermessung des Abstandes des Fahrzeugs zur Fahrbahnmarkierung den Abstand zum Fahrzeugrand. Anderweitige Mittel zur Bestimmung des Abstandes des Fahrzeugs zum Fahrbahnrand sind ebenfalls möglich.

In einer weiteren vorteilhaften Ausprägung der Erfindung wird bei zusätzlicher Annäherung der Fahrzeugposition an eine Infrastruktureinrichtung, an der eine akustische, insbesondere verbale, Kommunikation zwischen Infrastruktureinrichtung oder Personal der Infrastruktureinrichtung einerseits sowie dem Fahrzeugführer oder einem Fahrzeuginsassen andererseits zu erwarten ist, auf das Vorliegen oder Bevorstehen einer Gesprächssituation erkannt. Eine solche Infrastruktureinrichtung kann eine Mautstelle an einer Autobahn sein, an der üblicherweise eine Mautgebühr zu entrichten ist, die vielfach von Personen entgegengenommen wird. Eine solche Infrastruktureinrichtung kann beispielsweise ein Schnellrestaurant mit sogenanntem "Drive-In-Schalter" sein, an dem eine Bestellung verbal einem Restaurant-Mitarbeiter aufgegeben wird. Eine solche Infratruktureinrichtung kann ein Werkstor oder eine Werkseinfahrt an einem Werks- oder Firmengelände sein, an dem eine Kommunikation mit einem Werksschutz-Mitarbeiter erforderlich sein kann. Diese Aufzählung ist beispielhaft und nicht abschließend.

Die Annäherung der Fahrzeugposition an eine solche Infrastruktureinrichtung kann vorteilhaft durch Abgleich einer Ortsposition oder eine Abfolge von Ortspositionen des Fahrzeugs mit einer Karte bestimmt werden, in welcher Karte die geographische Lage der relevanten Infratruktureinrichtungen, gemäß vorherigen Beispielen also Mautstellen, Schnellrestaurants und Werkseinfahrten, vermerkt ist. Die Einrichtung zur Bestimmung einer jeweiligen Ortsposition des Fahrzeugs kann als Bestandteil eines Fahrzeugnavigationssystems vorliegen, welches aus empfangenen Signalen von Satelliten eines Satellitenortungssystems, wie GPS, eine Ortsposition feststellt. Die aus den Satellitensignalen bestimmte Ortsposition kann zur Erhöhung der Genauigkeit der Positionsbestimmung mit einer Straßenkarte abgeglichen werden, welche ebenfalls als Bestandteil eines Navigationssystems vorliegt. Die Annäherung der Fahrzeugposition an eine Infrastruktureinrichtung kann insbesondere vorteilhaft durch Beobachtung einer Folge von Fahrzeugpositionen festgestellt werden, wenn diese auf einem zu einer Infrastruktureinrichtung hin führenden Verkehrsweg liegen.

In weiterer Ausgestaltung kann das erfindungsgemäße Verfahren auch als sogenanntes lernendes oder selbst adaptierendes Verfahren ausgestaltet sein. Hierbei werden Verhaltensmuster eines Fahrzeuginsassen, insbesondere des Fahrzeugführers erfasst und aus einem aktuellen Verhalten und einer Historie von Verhaltensmustern auf das Vorliegen einer Gesprächssituation geschlossen. So kann beispielsweise an solchen Ortspositionen, an denen der Fahrzeugführer regelmäßig die Wiedergabelautstärke des Autoradios manuell reduziert, auf das Vorliegen einer Gesprächssituation geschlossen werden. In der Folge können bei Annäherung der Fahrzeugposition an diesen Ort die oder weitere Geräusche im Fahrzeuginnenraum erzeugende Einrichtung oder Einrichtungen zur Reduzierung der Geräusche automatisch gesteuert werden, insbesondere die Wiedergabelautstärke des Autoradios automatisch reduziert werden.

### Zeichnungen

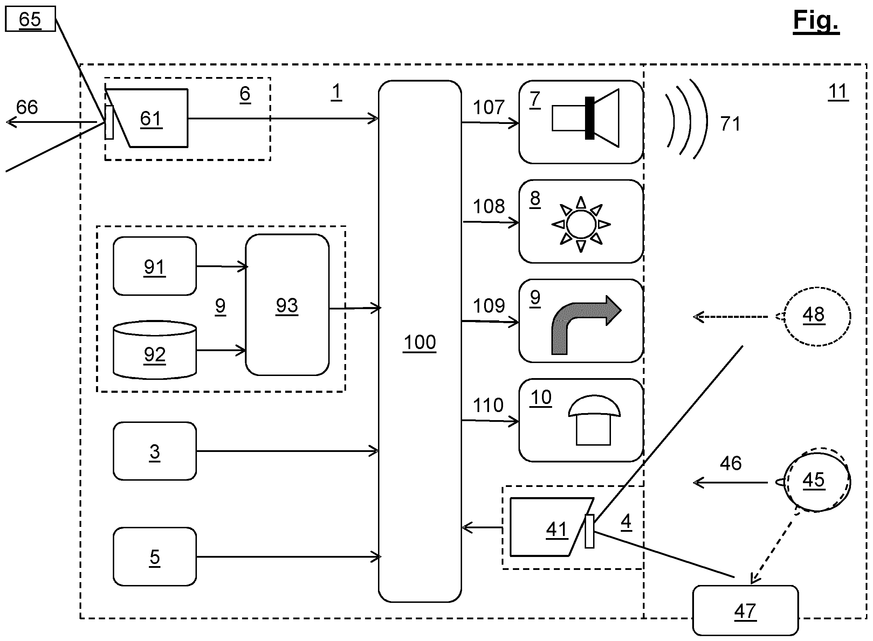

Ausführungsbeispiele der Erfindung sind in der Figur dargestellt und werden nachstehend näher erläutert.

Die Figur zeigt ein Blockschalt- und Funktionsbild einer Steuereinrichtung zur Durchführung des erfindungsgemäßen Verfahrens.

### Beschreibung der Ausführungsbeispiele

In der Figur ist ein Fahrzeug, in dem die erfindungsgemäße Steuereinrichtung 100 zur bedarfsabhängigen Geräuschverminderung angeordnet ist und betrieben wird, mit dem Bezugszeichen 1 bezeichnet.

Bei dem hier beschriebenen Ausführungsbeispiel sind in dem Fahrzeug mehrere, Geräusche oder Audiosignale erzeugende und abgebende Einrichtungen vorhanden. Dabei handelt es sich vorliegend um ein Autoradio 7, welches Rundfunksignale empfängt und die darin enthaltenen Programminformationen, also Unterhaltungsprogramm- oder Informationsprogramm-Informationen als akustische Signale 71 über einen Lautsprecher in eine Fahrgastzelle bzw. einen Fahrzeuginnenraum 11 ausgibt. Bei den Programminformationen kann es sich um Musikstücke, Nachrichten, Verkehrsdurchsagen oder ähnliches handeln. Ferner kann das Autoradio 7 auch über einen Medienspieler zum Abspielen von auf einem Speichermedium wie CD, DVD oder Speicherkarte gespeicherten Signalen, beispielsweise Musikstücke umfassen, die ebenfalls als akustische Signale 71 über Lautsprecher 71 in den Fahrzeuginnenraum 11 ausgegeben werden.

Als weitere Audiosignalquelle oder allgemeiner Geräuschquelle ist eine Fahrzeugklimatisierung 8, dabei insbesondere ein Gebläse, welches entweder unmittelbar oder mittelbar über den erzeugten Luftstrom und Ausströmgeräusche an Luftdüsen Geräusche im Innenraum 11 des Fahrzeugs 1 erzeugt, vorhanden. Daneben kann beispielsweise ein Fahrzeugnavigationssystem 9 vorhanden sein, das abhängig von einem aktuellen Fahrzeugstandort und einer berechneten Fahrroute von einem Startzu einem Zielort akustische Zielführungsinformationen, wie "An der nächsten Kreuzung rechts abbiegen" oder dergleichen über einen Lautsprecher in den Fahrzeuginnenraum 11 ausgibt. Beispielsweise kann als eine weitere Geräuschquelle ein Mobiltelefon 10 mit Freisprecheinrichtung vorhanden sein, wobei die Klingelsignale oder Sprachsignale eines mit diesem Mobiltelefon 10 verbundenen Gesprächs-Teilnehmers über den lautgeschalteten Lautsprecher des Mobiltelefons 10 oder über den Lautsprecher der Freisprecheinrichtung, mit der das Mobiltelefon verbunden ist, in den Fahrzeuginnenraum 11 ausgegeben werden.

Die Steuereinrichtung ist erfindungsgemäß dazu ausgebildet, im Falle einer Gesprächssituation im Fahrzeuginnenraum 11 den Pegel der genannten Geräuschquellen 7, 8, 9, 10 zumindest zu reduzieren. Es kann daneben auch vorgesehen sein, die Geräusche der oder einzelner der Geräuschquellen 7, 8, 9, 10 vollständig zu unterbinden durch Abschalten oder Stummschalten der jeweiligen Einrichtung 7, 8, 9, 10. Dazu erzeugt die Steuereinrichtung 100 Steuersignale 107, 108, 109 und 110 zur Ansteuerung angeschlossenen Einrichtungen 7, 8, 9 und 10.

Eine Gesprächssituation, insbesondere eine bevorstehenden Gesprächssituation, also die Intention eines Fahrzeugführers 45 oder eines weiteren Fahrzeuginsassen 48 werden auf Grundlage einer Beobachtung und Auswertung von Aktivitäten oder des Verhaltens des Fahrzeugführers 45 und/oder eines weiteren Fahrzeuginsassen 48 erkannt. Dazu greift die Steuereinrichtung 100 auf eine Sensorik zu, welche diese Informationen bereitstellt.

Beispielsweise kann ein Steuersignal, welches von einem Bedienelement 5 eines elektrischen Fensterhebers für das Fahrzeug-Seitenfenster 47 bei Betätigung des Bedienelements 5 erzeugt wird, erfasst werden. Dieses Signal zeigt der Steuereinrichtung 100 an, dass ein oder ein bestimmten Fahrzeug-Seitenfenster 47 geöffnet wird. Aus dieser Information schließt die Steuereinrichtung 100 auf das Vorliegen oder Bevorstehen eines Gesprächs mit einem Fahrzeugexternen, wie etwa einem Bediensteten an einer Mautstelle oder in einem Schnell restaurant, einem Werkschutzbediensteten oder einem Polizisten am Straßen rand im Rahmen einer Fahrzeug- oder Verkehrskontrolle oder eine ähnliche Gesprächssituation.

Weiterhin kann vorteilhaft eine Innenraum-Überwachungskamera 41 mit zugeordneter Bilderkennung, also kurz eine Innenraum-Videoüberwachung 4 vorgesehen sein. Die Kamera 41 ist dabei vorteilhaft im Bereich des Rückspiegels im oberen Bereich der Windschutzscheibe angeordnet und erfasst den gesamten Fahrzeuginnenraum 11, soweit dieser nicht durch Hindernisse verdeckt ist. Im Zusammenhang mit der vorliegenden Erfindung ist die Innenraum-Videoüberwachung 4 dazu ausgebildet, eine Kopfausrichtung und/oder Blickrichtung 46 des Fahrzeugführers 45 oder weiterer Fahrzeuginsassen zu erfassen. Darüber hinaus können auch etwa die Positionen der Hände des Fahrzeugführers oder weiterer Fahrzeuginsassen 48 absolut oder auch relativ zu dem Bedienelement 5 festgestellt werden.

Wird festgestellt, dass der Fahrzeugführer 45 oder ein Fahrzeuginsassen seinen Blick 46 in Richtung Fahrzeug-Seitenfenster 47 richtet oder seinen Kopf Richtung Fahrzeug-Seitenfenster 47 dreht und/oder dass der Fahrzeugführer 45 ein weiterer Fahrzeuginsasse des Fensterheber betätigen möchte oder dies tatsächlich tut, so wird auf das Vorliegen einer Gesprächsabsicht mit einem Fahrzeugexternen geschlossen und in der Folge die eine oder mehreren Geräusche 71 erzeugenden Einrichtungen 7, 8, 9 und/oder 10 zur Verringerung ihrer Geräusche angesteuert.

Die Reduktion der Lautstärke beispielsweise des Autoradios 7 kann derart an das Öffnen des Seitenfensters 47 gekoppelt, dass das Radio 7 bei einer bestimmten Fensterstellung leise geschaltet oder aber die Lautstärke kontinuierlich synchron zur Fensterstellung reduziert wird.

Eine Verfeinerung oder Plausiblisierung der Erkennung einer Gesprächssituation aus Beobachtung und Auswertung des Verhaltens von Fahrzeugführer und/oder Fahrzeuginsassen kann durch eine eine Ortspositions- und/oder FahrzeugBewegungserkennung erfolgen.

Eine Information über eine Bewegung oder einen Bewegungszustand des Fahrzeugs wird beispielsweise von einem Radsensor des Fahrzeugs zur Verfügung gestellt, aus welcher Information ein Signal für eine Geschwindigkeitsanzeige abgeleitet wird. Eine Information über den Bewegungszustand kann dabei unmittelbar aus dem Radsensor-Signal oder aus dem daraus abgeleiteten Geschwindigkeitssignal hergeleitet werden. Im vorliegenden Fall wird das Geschwindigkeitssignal 3, welches auf einem Datenbus des Fahrzeugs 1 zur Verfügung steht, genutzt, um eine Information über die Fahrzeuggeschwindigkeit zu erhalten.

Weiterhin greift die Steuereinrichtung 100 in vorteilhafter Ausführung der Erfindung auch auf Positionssignale des Navigationssystems 9 zu. Das Navigationssystem 9 umfasst zur Bereitstellung der Positionssignale in an sich bekannter Weise Ortungsmittel 91, etwa einen Empfänger für Satellitenortungssignale, wie GPS, an dessen Ausgang Ortskoordinaten der aktuellen Ortsposition des Satellitenempfängers 91 anstehen. Ferner weist das Navigationssystem 9 eine digitale Karte, im Falle eines Fahrzeugnavigationssystems insbesondere eine Straßenkarte 92 auf. Durch Abgleich der mittels Satellitenortung 91 bestimmten Position mit der Straßenkarte kann in an sich bekannter Weise die Ortungsgenauigkeit erhöht werden und eine straßen- oder auch fahrspurgenaue Positionsbestimmung erfolgen. Weiter können vorzugsweise in der Straßenkarte auch die Ortpositionen von Infrastruktureinrichtungen, wie Mautstellen, Einfahrten zu Werksgeländen oder andere vermerkt sein. Damit kann durch Vergleich einer Abfolge von Ortsposition und/oder durch Feststellung einer aktuell befahrenen Straßen eine Annäherung an eine solche Infrastruktureinrichtung festgestellt werden.

Zur Bestimmung der Ortsposition können ferner auch Signale einer Bilderkennungseinrichtung 6, umfassend eine Kamera 61 und eine zugeordnete, nicht separat dargestellte Bildauswertung, herangezogen werden. Die Kamera 61 ist dabei in Fahrtrichtung 66 des Fahrzeugs 1 ausgerichtet und erfasst die vor dem Fahrzeug liegende Fahrbahn sowie eine Fahrbahn-Randmarkierung 65. Auf Grundlage der erfassten Bilder kann die Bilderkennungseinrichtung etwa eine Annäherung des Fahrzeugs an den Fahrbahnrand feststellen. Es ist darüber hinaus auch möglich, in dem Kamerabild bestimmte Verkehrszeichen, wie etwa eine "Haltekelle" eines am Straßenrand stehenden Polizeibeamten zu erkennen.

Eine Gesprächssituation, insbesondere das Bevorstehen einer Gesprächssituation, oder anders ausgedrückt die Intention des Fahrzeugführers 45 oder eines weiteren Fahrzeuginsassen, wie eines Beifahrers 48 zur Führung eines Gesprächs kann daraus abgeleitet werden, dass eine Annäherung der Ortsposition des Fahrzeugs 1 an eine der genannten Infrastruktureinrichtungen erfolgt. So wird die Notwendigkeit einer verbalen Kommunikation zwischen Fahrzeugführer 45 und einem Bediensteten an einer Mautstelle angenommen, ebenso etwa die Notwendigkeit einer Kommunikation zwischen Fahrzeugführer 45 oder Fahrzeuginsassen 48 und einem Werksschutzbediensteten an einer Werkseinfahrt. Weiterhin kann auf die Intention eines Gesprächs mit einem Fahrzeugexternen angenommen werden, wenn sich die Fahrzeugposition einem Fahrzeugrand 65 annähert, was alleine mittels hochgenauer Ortung 93 oder Bilderkennung 6 oder eine Kombination beider Systeme feststellbar ist, und die Geschwindigkeit des Fahrzeugs verringert wird. Hier kann etwa eine Verkehrskontrolle durch die Polizei und eine intendierte Kommunikation mit einem Polizeibeamten angenommen werden oder die Absicht, einen Passanten nach dem Weg oder einer anderen Information zu fragen.

Wird beispielsweise bei Annäherung der Fahrzeugposition an eine Infrastruktureinrichtung oder den Fahrbahnrand und/oder bei Verminderung der Fahrzeuggeschwindigkeit zusätzlich festgestellt, dass der Fahrzeugführer 45 oder ein Fahrzeuginsassen seinen Blick 46 in Richtung Fahrzeug-Seitenfenster 47 richtet oder seinen Kopf Richtung Fahrzeug-Seitenfenster 47 dreht und/oder dass der Fahrzeugführer 45 oder ein weiterer Fahrzeuginsasse 48 den Fensterheber betätigen möchte oder dies tatsächlich tut, so wird auf das Vorliegen einer Gesprächsabsicht mit einem Fahrzeugexternen geschlossen und in der Folge die eine oder mehreren Geräusche 71 erzeugenden Einrichtungen 7, 8, 9 und/oder 10 zur Verringerung ihrer Geräusche angesteuert. Die Reduktion der Lautstärke beispielsweise des Autoradios 7 wird an das Öffnen des Seitenfensters 47 gekoppelt. Dabei kann das Radio 7 bei einer bestimmten Fensterstellung leise geschaltet werden oder aber die Lautstärke kontinuierlich synchron zur Fensterstellung reduziert werden.

Bei den oben beschriebenen Situationen handelt es sich um Beispiele, die den Gegenstand der vorliegenden Erfindung nicht beschränken sollen. Vielmehr sind auch weitere Situationen, in denen eine Gesprächsintention angenommen werden kann, vorstellbar und mit den beschriebenen Mitteln erkennbar. Diese werden von der vorliegenden Erfindung umfasst ebenso auch, wie etwa eine anderweitige Kombination der beschriebenen Sensorik zur Erkennung einer Gesprächsintention. Der Umfang der Erfindung ist durch die Ansprüche definiert.

## Patentansprüche

1. Verfahren zur automatischen Steuerung einer Einrichtung (7, 8, 9, 10), nämlich einer Lüftung oder Fahrzeug-Klimatisierung, welche Geräusche (71) im Innenraum (11) eines Fahrzeugs (1) erzeugt, wobei die Einrichtung (7, 8, 9, 10) zur Reduzierung der von ihr erzeugten Geräusche (71) im Fahrzeuginnenraum (11) in Abhängigkeit von der Erkennung einer Gesprächssituation im Fahrzeuginnenraum (11) gesteuert wird, wobei zur Erkennung des Vorliegens oder Bevorstehens einer Gesprächssituation Aktivitäten eines Fahrzeuginsassen (45, 48) erfasst und ausgewertet werden, **dadurch gekennzeichnet, dass** dabei eine Blick- oder Kopfausrichtung (46) eines Fahrzeuginsassen (45) erfasst wird und auf Grundlage einer Blick- oder Kopfausrichtung in Richtung Fahrzeug-Seitenfenster (47) das Vorliegen oder Bevorstehen einer Gesprächssituation erkannt wird.

2. Verfahren nach Anspruch 1, **dadurch gekennzeichnet, dass** das Verfahren zusätzlich den Schritt enthält, dass aus der Betätigung eines Fensterhebers zum Öffnen eines Fahrzeugfensters (47) auf das Vorliegen oder Bevorstehen einer Gesprächssituation erkannt wird.

3. Verfahren nach einem der vorhergehenden Ansprüche, **dadurch gekennzeichnet, dass** zur Erfassung von Aktivitäten eines Fahrzeuginsassen (45, 48) eine Innenraum-Videoüberwachung (4) eingesetzt wird.

4. Verfahren nach einem der vorhergehenden Ansprüche, dass die Erkennung des Vorliegens oder Bevorstehens einer Gesprächssituation nach einem der vorhergehenden Ansprüche zusätzlich durch Auswertung von Bewegungs- und/oder Ortspositions-Information des Fahrzeugs (1) gestützt wird.

5. Verfahren nach Anspruch 4, **dadurch gekennzeichnet, dass** bei zusätzlicher Reduzierung einer Fahrzeuggeschwindigkeit und Annäherung einer Fahrzeugposition an einen Fahrbahnrand auf das Vorliegen oder Bevorstehen einer Gesprächssituation erkannt wird

6. Verfahren nach Anspruch 4 oder 5, **dadurch gekennzeichnet, dass** bei zusätzlicher Annäherung einer Fahrzeugposition an eine Infrastruktureinrichtung, an der eine akustische, insbesondere verbale, Kommunikation zwischen Infrastruktureinrichtung oder Personal der Infrastruktureinrichtung einerseits sowie dem Fahrzeugführer oder einem Fahrzeuginsassen andererseits erfolgt, auf das Vorliegen oder Bevorstehen einer Gesprächssituation erkannt wird.

7. Steuereinrichtung (100) in Verbindung mit einer Einrichtung, nämlich einer Lüftung oder Fahrzeug-Klimatisierung, wobei die Steuereinrichtung zur automatischen Steuerung der Einrichtung (7, 8, 9, 10) ausgebildet ist, wobei die Einrichtung Geräusche (71) im Innenraum (11) eines Fahrzeugs (1) erzeugt, mit Erkennungsmitteln (100) zur Erkennung einer Gesprächssituation im Fahrzeuginnenraum (11), ausgebildet zur Erzeugung eines Steuersignals (107, 108, 109, 110) zur Ansteuerung der Einrichtung (7, 8, 9, 10) zur Reduzierung der von ihr erzeugten Geräusche (71) im Fahrzeuginnenraum (11) in Abhängigkeit von der Erkennung einer Gesprächssituation im Fahrzeuginnenraum (11) mittels der Erkennungsmittel (100), wobei die Erkennungsmittel (100) zur Erkennung auf das Vorliegen oder Bevorstehen einer Gesprächssituation auf Grundlage einer Erfassung und Auswertung von Aktivitäten eines Fahrzeuginsassen (45, 48) ausgebildet sind, **dadurch gekennzeichnet, dass** Mittel vorgesehen sind, eine Blick- oder Kopfausrichtung (46) eines Fahrzeuginsassen (45) zu erfassen und auf Grundlage einer Blick- oder Kopfausrichtung in Richtung Fahrzeug-Seitenfenster (47) das Vorliegen oder Bevorstehen einer Gesprächssituation zu erkennen.

8. Steuereinrichtung nach Anspruch 7, weitergebildet zur Durchführung des Verfahrens nach mindestens einem der Ansprüche 2 bis 6.

## Claims

1. Method for the automatic control of a device (7, 8, 9, 10), specifically a ventilation device or a vehicle air-conditioning device which generates noise (71) in the passenger compartment (11) of a vehicle (1), wherein the device (7, 8, 9, 10) is controlled to reduce the noise (71) generated by it in the passenger compartment (11) of the vehicle in accordance with the detection of a conversation situation in the passenger compartment (11) in the vehicle, wherein in order to detect that a conversation situation is present or imminent activities of a vehicle occupant (45, 48) are detected and evaluated, **characterized in that**
in this context a viewing orientation or head orientation (46) of a vehicle occupant (45) is detected and it is detected whether a conversation situation is present or imminent on the basis of a viewing orientation or head orientation in the direction of the vehicle side window (47).

2. Method according to Claim 1, **characterized in that** the method additionally contains the step that it is detected that the conversation situation is present or imminent from the activation of a window lever in order to open a vehicle window (47) .

3. Method according to one of the preceding claims, **characterized in that** a passenger compartment video monitoring device (4) is used to detect activities of a vehicle occupant (45, 48).

4. Method according to one of the preceding claims, **characterized in that** the detection of whether a conversation situation is present or imminent according to one of the preceding claims is additionally supported by the evaluation of movement information and/or location position information of the vehicle (1).

5. Method according to Claim 4, **characterized in that** when a vehicle speed is additionally reduced and when the position of the vehicle approaches the edge of the carriageway it is detected that a voice situation is present or imminent.

6. Method according to Claim 4 or 5, **characterized in that** when a position of the vehicle additionally approaches an infrastructure device at which an acoustic, in particular verbal, communication takes place between an infrastructure device or personnel of the infrastructure device, on the one hand, and the driver of the vehicle or a vehicle occupant, on the other, it is detected that a conversation situation is present or imminent.

7. Control device (1) in conjunction with a device, specifically a ventilation device or vehicle air-conditioning device, wherein the control device is designed to control the device (7, 8, 9, 10) automatically, wherein the device generates noise (71) in the passenger compartment (11) of a vehicle (1), having detection means (100) for detecting a conversation situation in the passenger compartment (11) of the vehicle, designed to generate a control signal (107, 108, 109, 110) for actuating the device (7, 8, 9, 10) to reduce the noise (71), generated by it, in the passenger compartment (11) of the vehicle in accordance with the detection of a conversation situation in the passenger compartment (11) of the vehicle by means of the detection means (100), wherein the detection means (100) are designed to detect whether a conversation situation is present or imminent on the basis of the detection and evaluation of activities of the vehicle occupant (45, 48), **characterized in that** means are provided for sensing a viewing orientation or head orientation (46) of a vehicle occupant (45) and for detecting whether a conversation situation is present or imminent on the basis of a viewing orientation or head orientation in the direction of a vehicle side window (47).

8. Control device according to Claim 7, developed for carrying out the method according to at least one of Claims 2 to 6.

## Revendications

1. Procédé de commande automatique d'un dispositif (7, 8, 9, 10), à savoir d'un système de ventilation ou de climatisation de véhicule, qui produit un bruit (71) dans l'habitacle (11) d'un véhicule (1), dans lequel le dispositif (7, 8, 9, 10) est commandé en vue de réduire les bruits (71) qu'il produit dans l'habitacle du véhicule (11) en fonction de la reconnaissance d'une situation de conversation dans l'habitacle (11) du véhicule, dans lequel, pour reconnaître la présence ou l'imminence d'une situation de conversation, des activités d'un occupant (45, 48) du véhicule sont détectées et évaluées,
**caractérisé en ce qu'**à cet effet, une orientation (46) du regard ou de la tête d'un occupant (45) du véhicule est détectée et la présence ou l'imminence d'une situation de conversation est reconnue sur la base d'une orientation du regard ou de la tête en direction de vitres latérales (47) du véhicule.

2. Procédé selon la revendication 1, **caractérisé en ce que** le procédé comprend en outre l'étape consistant à reconnaître la présence ou l'imminence d'une situation de conversation à partir de l'actionnement d'un lève-vitre en vue d'ouvrir une fenêtre (47) du véhicule.

3. Procédé selon l'une des revendications précédentes, **caractérisé en ce qu'**un système de surveillance vidéo d'habitacle (4) est utilisé pour détecter des activités d'un occupant (45, 48) du véhicule.

4. Procédé selon l'une des revendications précédentes, **caractérisé en ce que** la reconnaissance de la présence ou de l'imminence d'une situation de conversation selon l'une des revendications précédentes est en outre complétée par l'évaluation d'informations de mouvement et/ou de localisation du véhicule (1).

5. Procédé selon la revendication 4, **caractérisé en ce que** lorsqu'une vitesse du véhicule est réduite de manière supplémentaire et qu'une position du véhicule se rapproche d'un bord de route, la présence ou l'imminence d'une situation de conversation est reconnue.

6. Procédé selon la revendication 4 ou 5, **caractérisé en ce que**, lorsqu'une position du véhicule se rapproche en outre d'une installation d'infrastructure au niveau de laquelle une communication acoustique, notamment verbale, a lieu entre l'installation d'infrastructure ou le personnel de l'installation d'infrastructure d'une part et le conducteur du véhicule ou un occupant du véhicule d'autre part, la présence ou l'imminence d'une situation de conversation est reconnue.

7. Dispositif de commande (100) en liaison avec un dispositif, à savoir un système de ventilation ou de climatisation de véhicule, dans lequel le dispositif de commande est adapté pour commander automatiquement le dispositif (7, 8, 9, 10), dans lequel le dispositif produit des bruits (71) dans l'habitacle (11) d'un véhicule (1), comprenant des moyens de reconnaissance (100) destinés à reconnaître une situation de conversation dans l'habitacle (11) du véhicule, lesquels moyens de reconnaissance sont conçus pour produire un signal de commande (107, 108, 109, 110) destiné à actionner le dispositif (7, 8, 9, 10) en vue de réduire les bruits (71) qu'il produit dans l'habitacle (11) du véhicule en fonction de la reconnaissance d'une situation de conversation dans l'habitacle (11) du véhicule à l'aide des moyens de reconnaissance (100),
dans lequel les moyens de reconnaissance (100) sont conçus pour reconnaître la présence ou l'imminence d'une situation de conversation sur la base de la détection et de l'évaluation d'activités d'un occupant (45, 48) du véhicule,
**caractérisé en ce qu'**il est prévu des moyens destinés à détecter une orientation (46) du regard ou de la tête d'un occupant (45) du véhicule et à reconnaître la présence ou l'imminence d'une situation de conversation sur la base d'une orientation du regard ou de la tête en direction de vitres latérales (47) du véhicule.

8. Dispositif de commande selon la revendication 7, qui est en outre conçu pour mettre en œuvre le procédé selon au moins l'une des revendications 2 à 6.
